# EUROPÄISCHE PATENTANMELDUNG

(11) **EP 1 748 554 A1**
(43) Veröffentlichungstag der Anmeldung: **31.01.2007**
(21) Anmeldenummer: 06117778.8
(22) Anmeldetag: 25.07.2006
(51) Int. Cl.: H03G 5/22, H04B 1/16

(54) **Audiosignal-Wiedergabevorrichtung**

(30) Priorität: 27.07.2005 DE 102005035094
(71) Anmelder: ROBERT BOSCH GMBH, 70442 Stuttgart (DE)
(72) Erfinder: Montag, Christoph, 31134 Hildesheim (DE); Risse, Marcus, 31139 Hildesheim (DE); Sahrhage, Joerg, 31139 Hildesheim (DE)

(57) **Zusammenfassung**

Eine Audiosignal-Wiedergabevorrichtung (1) zur Wiedergabe von über potentiell störbehaftete Kanäle übermittelten Audiosignalen (AS) mit mindestens einer Reduktionseinheit (3,4) zur Reduktion von Störungen der Audiosignale (AS) in Abhängigkeit von einem Störgrad. Eine Erfassungseinheit (5) ist zur Erfassung der spektralen Zusammensetzung des Audiosignals (AS) und Ermittlung einer Wahrnehmbarkeitsgröße der Störungen in Abhängigkeit von der spektralen Zusammensetzung ausgebildet. Die Wahrnehmbarkeitsgröße wird als Steuersignal zu der mindestens einen Reduktionseinheit (3,4) zur Störreduktion in Abhängigkeit von der Wahrnehmbarkeitsgröße geleitet.

## Beschreibung

Die Erfindung betrifft eine Audiosignal-Wiedergabevorrichtung zur Wiedergabe von über potentiell störbehaftete Kanäle übermittelte Audiosignale und mit mindestens einer Reduktionseinheit zur Reduktion des Störgrades der Audiosignale in Abhängigkeit von einem Störgrad.

Derartige Audiosignal-Wiedergabevorrichtungen sind beispielsweise in Form von Autoradios grundsätzlich bekannt, die in empfangenen Rundfunksignalen enthaltene Audiosignale über angeschlossene Lautsprecher wiedergeben. Rundfunkempfänger, wie z. B. Autoradios verfügen oftmals über eine Einrichtung zur Klangbeeinflussung, um beispielsweise durch Bass- und Höheneinstellung eine frequenzselektive Verstärkung nieder- und hochfrequenter Anteile des wiederzugebenden Audiosignals oder mit einem Equalizer eine gezielte frequenzbandspezifische Verstärkungseinstellung zu ermöglichen.

Insbesondere im Autoradio ist der Rundfunkempfang oftmals durch verschiedenste Einflüsse gestört. Dazu gehören ortsabhängige Einbrüche der Feldstärke, Mehrwegempfangsstörungen, Nachbarkanalstörungen etc. Diese Empfangsstörungen wirken sich im Audiosignal als mehr oder weniger lange breitbandige "Spratzer" aus. Diese Störungen können im Empfänger eines Autoradios von verschiedenen Detektoren detektiert werden. In Abhängigkeit von der Stärke der Störungen können im Empfänger verschiedene Maßnahmen eingeleitet werden, um die Störungen weniger stark hörbar zu machen, d. h. die Störungen zu verschleiern. Eine Maßnahme ist beispielsweise, die Stereokanaltrennung zu reduzieren, da das Mono-Signal meist weniger von Störungen betroffen ist, als ein Mehrkanalsignal. Eine andere Möglichkeit besteht darin, höhere Frequenzen im Audiosignal zunehmend zu unterdrücken, d. h. eine störabhängige Höhenabsenkung vorzunehmen. Dies wird auch als High-Cut bezeichnet.

Aus der EP 1 342 316 B1 ist eine Audiosignal-Wiedergabevorrichtung bekannt, bei der die Einsatzschwelle für die störabhängige Höhenabsenkung durch den mittleren Frequenzhub des Empfangssignals gesteuert wird, der ein Maß für die Modulation und somit für den mittleren Pegel des Audiosignals ist. Bei einem kleinen Signalpegel setzen die Maßnahmen zur Störungsverschleierung schon bei geringen Störungen ein, da diese dann deutlich wahrnehmbarer sind als bei höherem Audiosignalpegel. Für das Maß der je nach Störung erforderlichen Dämpfung hochfrequenter Anteile des Audiosignals wird zudem eine durch einen Equalizer oder einen Höhensteller voreingestellte Höhenanhebung oder Höhenabsenkung des bereits abgesenkten Audiosignals berücksichtigt.

Ausgehend davon ist es Aufgabe der Erfindung eine verbesserte Audiosignal-Wiedergabevorrichtung zu schaffen, mit der die Reduktion des Störgrades des Audiosignals, insbesondere die Höhenabsenkung (High-Cut) verbessert und eine übermäßige bzw. nicht ausreichende Reduktion vermieden wird.

Die Aufgabe wird mit der Audiosignal-Wiedergabevorrichtung der eingangs genannten Art dadurch gelöst, dass eine Erfassungseinheit zur Erfassung der spektralen Zusammensetzung des Audiosignals und zur Ermittlung einer Wahrnehmbarkeitsgröße der Störungen von der spektralen Zusammensetzung ausgebildet ist und die Wahrnehmbarkeisgröße als Steuersignal zu der mindestens einen Reduktionseinheit zur Störreduktion in Abhängigkeit von der Wahrnehmbarkeitsgröße geleitet wird.

Der Erfindung liegt die Erkenntnis zugrunde, dass nicht nur der Hub des Audiosignals und eine voreingestellte Höhenänderung des Audiosignals die Störungsverschleierung beeinflusst, sondern die spektrale Verteilung der Signalpegel die Qualität der Störungsverschleierung maßgeblich beeinflusst. Die spektrale Zusammensetzung des Audiosignals kann nicht einfach aus einer voreingestellten Höhenanpassung und dem Signalhub des Audiosignals abgeleitet werden. Erst durch Ermittlung einer Wahrnehmbarkeitsgröße, die ein Maß für die akustische Wahmehmbarkeit der Störungen ist, in Abhängigkeit von der spektralen Zusammensetzung des Audiosignals und Ansteuerung der Reduktionseinheiten in Abhängigkeit von der Wahrnehmbarkeitsgröße ist eine optimale Störreduzierung möglich.

Vorteilhaft ist es, wenn die Erfassungseinheit zwei oder mehr auf ein jeweiliges Spektrum eingestellte Bandpassfilter und Störpegeldetektoren an den Bandpassfiltern zur Bestimmung der Signalpegel der jeweiligen spektralen Anteile des noch nicht beeinflussten Audiosignals und eine Auswerteeinheit zur Ermittlung der Wahrnehmbarkeitsgröße aus den Signalpegeln hat. Durch die Bandpass-Filter mit unterschiedlichen Durchlassbereichen kann das Audiosignal in einzelne Signale unterschiedlicher Frequenzbereiche aufgeteilt werden.

Vorzugsweise ist eine Integrationseinheit am Ausgang der Störgraderfassungseinheit zur langsamen Nachführung von störgradabhängigen Einsatzschwellen der Absenkeinheit vorgesehen. Damit ist eine optimale Nachführung der Einsatzschwellen für die Absenkungseinheit mit geeigneten Zeitkonstanten möglich.

Die Erfassungseinheit kann an den Ausgang eines Audiosignal-Demodulators geschaltet sein, um die spektrale Zusammensetzung des demodulierten Audiosignals vor der Stereo-Decodierung zu erfassen.

Eine von der Erfassungseinheit angesteuerte Reduktionseinheit kann als High-Cut-Einheit an den Ausgang eines Stereodecoders geschaltet sein, der mit dem Ausgang des Audiosignal-Demodulators verbunden ist.

Alternativ oder zusätzlich zu der High-Cut-Einheit kann die Absenkung des Störgrades auch mit der Stereo-Decodereinheit erfolgen, die von der Erfassungseinheit angesteuert wird.

Weiterhin ist es vorteilhaft, beispielsweise mit der High-Cut-Einrichtung lediglich die hochfrequenten Anteile des Audiosignals in Abhängigkeit von der Wahrnehmbarkeitsgröße abzusenken.

Die Erfindung wird nachfolgend anhand der beigefügten Zeichnung mit einem Ausführungsbeispiel näher erläutert. Es zeigt:

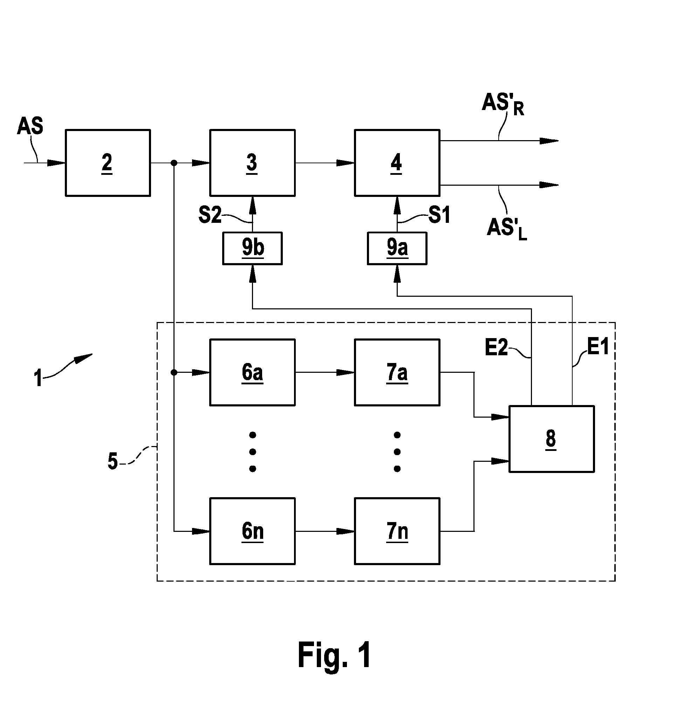

Figur 1 - Blockschaltbild eines Teils einer Audiosignal-Wiedergabevorrichtung mit Störgraderfassungseinheit.
Die Figur 1 lässt ein Blockschaltbild eines Ausschnitts einer AudiosignalWiedergabevorrichtung 1 erkennen, die in an sich bekannter Weise eine Reihenschaltung aus Demodulator 2 zur Demodulation eines modulierten Audiosignals AS, einen Stereodecoder 3 am Ausgang des Demodulators 2 und einer Stör-Reduktionseinheit 4 am Ausgang des Stereodecoders 3 hat. Am Ausgang der Reduktionseinheit 4 steht ein klangbeeinflusstes Audiosignal AS'_{R} und AS'_{L} für den rechten und linken Kanal einer nachfolgenden Verstärker- und Lautsprecherwiedergabeeinheit (nicht dargestellt) an.

Die beschriebene Reihenschaltung wird beispielsweise in Autoradios eingesetzt, um ein frequenzmoduliertes Rundfunksignal zu empfangen und wiederzugeben.

An den Ausgang des Demodulators 2 ist eine Erfassungseinheit 5 geschaltet, die zur Ermittlung einer Wahrnehmbarkeitsgröße als Maß für die Wahmehmbarkeit von Störungen ausgebildet ist. Ein erster Signalausgang für ein erstes Steuersignal S₁ ist mit der Reduktionseinheit 4 verbunden, um insbesondere hochfrequente Anteile des Audiosignals in Abhängigkeit von der Wahrnehmbarkeitsgröße abzusenken und damit Störungen zu verschleiern.

Ein zweiter Signalausgang der Erfassungseinheit 5 für ein zweites Steuersignal S₂ ist mit dem Stereodecoder 3 verbunden, um durch Reduzierung der Stereokanaltrennung Störungen zu vermindern.

Die Erfassungseinheit 5 hat eine Anzahl n von Bandpass-Filtern mit n = 2, 3, 4, 5 oder mehr, um das demodulierte FM-Empfangssignal einer aus den Bandpass-Filtern 6a, ... 6n bestehenden Filterbank zuzuführen. Die Bandpass-Filter 6a,...6n haben unterschiedliche Durchlassbereiche, so dass das demodulierte FM-Empfangssignal in eine Anzahl n spektraler Bereiche aufgeteilt wird. Die Ausgangssignale der Bandpassfilter 6a, ... 6n sind jeweils mit einem zugeordneten Pegelmesser 7a,...7n verbunden, so dass an den Ausgängen der Pegelmesser 7a,...7n das demodulierte FM-Empfangssignals in den verschiedenen Frequenzbereichen anliegt. Hieraus kann in einer nachfolgenden Auswerteeinheit 8 ermittelt werden, welche Störungen noch durch das Audiosignal maskiert werden und bei welcher Stärke der Störungen die Maßnahmen zur Störungsverminderung einsetzen sollen. Die ermittelten Einsatzschwellen E₁, E₂ werden als Maß für die Wahmehmbarkeit von Störungen jeweils einer Verzögerungseinheit 9a, 9b zugeführt und dort mit geeigneten Zeitkonstanten nachgeführt und als Steuersignal S₁, S₂ der Reduktionseinheit 4 und ggf. dem Stereo-Decoder zugeführt.

## Patentansprüche

1. Audiosignal-Wiedergabevorrichtung (1) zur Wiedergabe von über potentiell störbehaftete Kanäle übermittelte Audiosignale (AS) mit mindestens einer Reduktionseinheit (3, 4) zur Reduktion von Störungen der Audiosignale (AS) in Abhängigkeit von einem Störgrad, **dadurch gekennzeichnet, dass** eine Einheit (5) zur Erfassung der spektralen Zusammensetzung des abzusenkenden Audiosignals (AS) und Ermittlung einer Wahrnehmbarkeitsgröße der Störungen von der spektralen Zusammensetzung ausgebildet ist und die Wahrnehmbarkeitsgröße als Steuersignal zu der mindestens einen Reduktionseinheit (3, 4) zur Störreduktion in Abhängigkeit von der Wahrnehmbarkeitsgröße geleitet wird.

2. Audiosignal-Wiedergabevorrichtung (1) nach Anspruch 1, **dadurch gekennzeichnet, dass** die Erfassungseinheit (5) zwei oder mehr auf ein jeweiliges Spektrum eingestellte Bandpassfilter (6a) und Signalpegeldetektoren am Ausgang der Bandpassfilter (6a) zur Bestimmung der Signalpegel der jeweiligen spektralen Anteile des Audiosignals (AS) und eine Auswerteeinheit (8) zur Ermittlung der Wahrnehmbarkeitsgröße aus den Signalpegeln hat.

3. Audiosignal-Wiedergabevorrichtung (1) nach Anspruch 1 oder 2, **gekennzeichnet durch** eine Integrationseinheit (9a, 9b) am Ausgang der Erfassungseinheit (5) zur langsamen Nachführung von störgradabhängigen Einsatzschwellen der mindestens einen Reduktionseineheit (3, 4).

4. Audiosignal-Wiedergabevorrichtung (1) nach einem der vorhergehenden Ansprüche, **dadurch gekennzeichnet, dass** ein Audiosignaleingang der Erfassungseinheit (5) mit dem Ausgang eines Audiosignal-Demodulators (2) verbunden ist.

5. Audiosignal-Wiedergabevorrichtung (1) nach Anspruch 4, **dadurch gekennzeichnet, dass** eine Reduktionseinheit (4) an den Ausgang eines Stereo-Decoders (3) am Ausgang des Audiosignal-Demodulators (2) geschaltet ist.

6. Audiosignal-Wiedergabevorrichtung (1) nach einem der vorhergehenden Ansprüche, **dadurch gekennzeichnet, dass** eine der Reduktionseinheiten (4) zur Absenkung hochfrequenter Anteile des Audiosignals (AS) vorgesehen ist.

7. Audiosignal-Wiedergabevorrichtung (1) nach einem der vorhergehenden Ansprüche, **dadurch gekennzeichnet, dass** als eine der Reduktionseinheiten (4) ein Stereodecoder (3) genutzt wird.

8. Audiosignal-Wiedergabevorrichtung (1) nach einem der vorhergehenden Ansprüche, **dadurch gekennzeichnet, dass** eine der Reduktionseinheiten (4) eine High-Cut-Einheit (4) ist.
